# EUROPEAN PATENT APPLICATION

(11) **EP 4 531 512 A1**
(43) Date of publication of application: **02.04.2025**
(21) Application number: 24198023.4
(22) Date of filing: 02.09.2024
(51) Int. Cl.: H05K 7/20, B01D 46/00, B01D 46/12, B01D 46/58

(54) **DATA CENTER COOLING UNIT FILTER DEVICE**

(30) Priority: 28.09.2023 US 202363541030 P; 26.08.2024 US 202418815300
(71) Applicant: Vertiv Corporation, Westerville, OH 43082 (US)
(72) Inventor: Masetto, Filippo, CAP 35010 Villanova di Camposampiero (IT); Malosso, Cristiano, CAP 35020 Albignasego (IT); Moscardo, Enrico, CAP 30031 Sambruson di Dolo (IT)
(74) Representative: Cousens, Nico

(57) **Abstract**

A filter device may include a plurality of sections including one or more panels formed from one or more air filter media and one or more hinges arranged between two or more sections of the plurality of sections. The filter device may be disposed within a space and may be retrieved from the space via a direct access opening within a cooling system. When the filter device is disposed within the space, the filter device may be arranged parallel to a coil. When the filter device is retrieved from the space, a first section of the filter device may bend via a first hinge of the one or more hinges to retrieve the first section from the space via the direct access opening of the cooling system.

## Description

### CROSS-REFERENCE TO RELATED APPLICATIONS

The present application claims the benefit under 35 U.S.C. § 119(e) of U.S. Provisional Application No. 63/541,030, filed September 28, 2023, which is incorporated herein by reference in the entirety.

### TECHNICAL FIELD

The present disclosure generally relates to the field of data centers, and more particularly, to an air filter device for cooling units of data centers.

### BACKGROUND

The data center market is moving away from raised floor designs, where a floor was installed below the data center equipment to allow for cabling and cooling air flow to be run under the floor to the equipment located on top of the floor. Balancing the temperature in data centers is important, however, the movement away from raised floor design presents difficulties for cooling units by decreasing the amount of space. For example, given the decreased amount of space, the cooling unit needs to provide more air flow for proper distribution. As such, it would be advantageous to provide a system or apparatus to remedy the shortcomings of the conventional approaches identified above.

### SUMMARY

A cooling system is disclosed in accordance with one or more embodiments of the present disclosure. In embodiments, the cooling system includes a filter device configured to be disposed within a space of the cooling system. In embodiments, the filter device includes a plurality of sections including one or more panels, where the one or more panels are defined by one or more air filter media. In embodiments, the filter device includes one or more hinges arranged between two or more sections of the plurality of sections. In embodiments, the cooling system includes a direct access opening, where the direct access opening is configured to provide access to the space of the cooling system, where the filter device is configured to be disposed within the space, and where the filter device configured to be retrieved from the space via the direct access opening. In embodiments, the cooling system includes a coil arranged adjacent the space of the cooling system. In embodiments, the cooling system includes a fan. When the filter device is installed within the space, the filter device is arranged parallel to the coil and when the filter device is retrieved from the space via the direct access opening, a first section is configured to bend via at least a first hinge of the one or more hinges to retrieve the first section from the space via the direct access opening.

A filter device is disclosed in accordance with one or more embodiments of the present disclosure. In embodiments, the filter device includes a plurality of sections including one or more panels, where the one or more panels are defined by one or more air filter media. In embodiments, the filter device includes one or more hinges arranged between two or more sections of the plurality of sections, where the filter device is configured to be disposed within a space, where the filter device is configured to be retrieved from the space, when the filter device is disposed within the space, the filter device is configured to be arranged parallel or adjacent to a coil, and when the filter device is retrieved from the space, a first section is configured to bend via a first hinge of the one or more hinges to retrieve the first section from the space.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A illustrates a schematic view of a cooling unit including a conventional filter module.
FIG. 1B illustrates a schematic view of the cooling unit including the conventional filter module.
FIG. 2A illustrates a schematic view of a filter device, in accordance with one or more embodiments of the present disclosure.
FIG. 2B illustrates a schematic view of a filter device, in accordance with one or more embodiments of the present disclosure.
FIG. 2C illustrates a schematic view of a filter device, in accordance with one or more embodiments of the present disclosure.
FIG. 2D illustrates a schematic view of a filter device, in accordance with one or more embodiments of the present disclosure.
FIG. 2E illustrates a schematic view of a plurality of filter devices, in accordance with one or more embodiments of the present disclosure.
FIG. 3A illustrates a schematic side view of a cooling unit including the filter device, in accordance with one or more embodiments of the present disclosure.
FIG. 3B illustrates a schematic perspective view of a cooling unit including the filter device, in accordance with one or more embodiments of the present disclosure.
FIG. 3C illustrates a schematic side view of a top portion of a cooling unit, in accordance with one or more embodiments of the present disclosure.
FIG. 3D illustrates a schematic perspective view of a cooling unit including the plurality of filter devices, in accordance with one or more embodiments of the present disclosure.
FIG. 4A illustrates a schematic side view of a cooling unit including the filter device in a fully installed position, in accordance with one or more embodiments of the present disclosure.
FIG. 4B illustrates a schematic side view of a cooling unit including the filter device in a partially retrieved position, in accordance with one or more embodiments of the present disclosure.
FIG. 4C illustrates a schematic side view of a cooling unit including the filter device in a partially retrieved position, in accordance with one or more embodiments of the present disclosure.
FIG. 4D illustrates a schematic side view of a cooling unit including the filter device in a partially retrieved position, in accordance with one or more embodiments of the present disclosure.
FIG. 5A illustrates a schematic side view of a cooling unit including the filter device, in accordance with one or more embodiments of the present disclosure.
FIG. 5B illustrates a schematic perspective view of a cooling unit including the plurality of filter devices, in accordance with one or more embodiments of the present disclosure.
FIG. 6A illustrates a schematic side view of a cooling unit including the filter device in a fully installed position, in accordance with one or more embodiments of the present disclosure.
FIG. 6B illustrates a schematic side view of a cooling unit including the filter device in a partially retrieved position, in accordance with one or more embodiments of the present disclosure.
FIG. 7A illustrates a schematic view of a dual-coil cooling unit including the filter device, in accordance with one or more embodiments of the present disclosure.
FIG. 7B illustrates a schematic side view of the dual-coil cooling unit including the filter device, in accordance with one or more embodiments of the present disclosure.
FIG. 7C illustrates a schematic view of the dual-coil cooling unit including the filter device, in accordance with one or more embodiments of the present disclosure.

### DETAILED DESCRIPTION

Reference will now be made in detail to the subject matter disclosed, which is illustrated in the accompanying drawings.

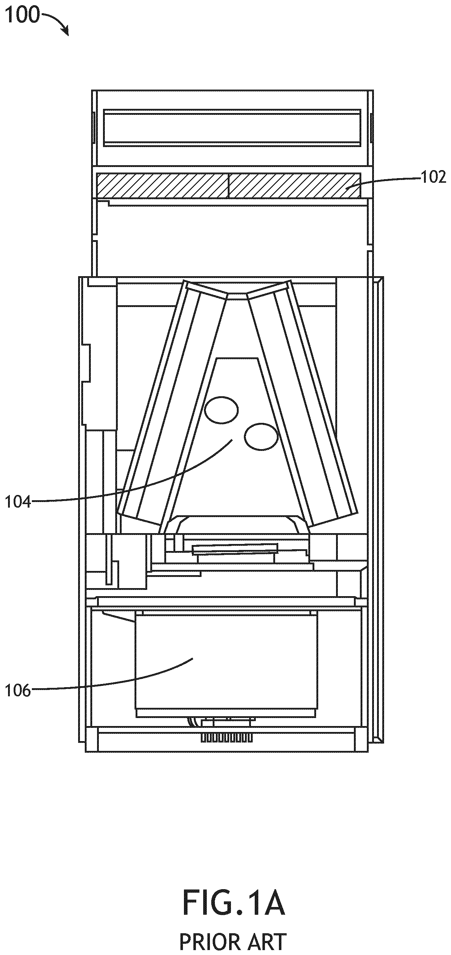

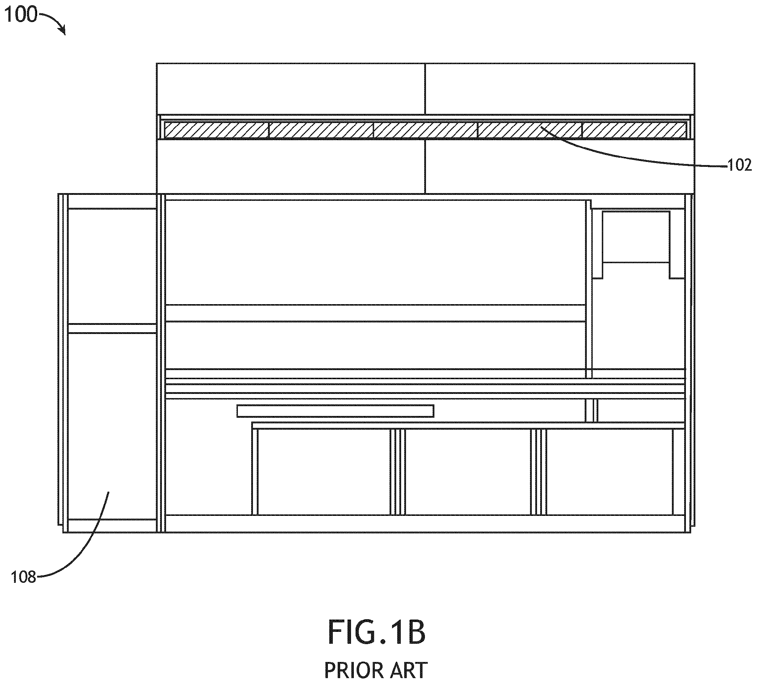

The data center market is moving away from raised floor designs, where a floor was installed below the data center equipment to allow for cabling and cooling air flow to be run under the floor to the equipment located on top of the floor. Balancing the temperature in data centers is important, however, the movement away from the raised floor design presents difficulties for cooling units by decreasing the amount of space. In particular, the cooling units need to provide more air flow for proper distribution, which is difficult for conventional cooling units. For example, as shown in FIGS. 1A and 1B, in conventional cooling units an external filter module (e.g., an upper portion of a cooling unit 100) is required to increase the filter surface area, which increases the cooling unit's dimension and cost. In the example shown in FIG. 1A, the filter 102 is installed in an upper portion of the cooling unit 100, where coils 104 and a fan 106 are located a distance away from the filter 102 (e.g., approximately 1 meter or more). In this regard, there is no direct contact between the coils 104 and the filter 102, which makes it difficult for the cooling unit 100 to provide efficient air flow for proper distribution. Further, in the example shown in FIG. 1B, the filter 102 may be installed in an upper portion of the cooling unit 100 away from a compressor location 108. As such, it would be advantageous to provide a system or apparatus to remedy the shortcomings of the conventional approaches identified above.

Accordingly, the present disclosure is directed to a filter device for a cooling unit system within a data center. More particularly, the present disclosure is directed to a filter device for a cooling unit system, where the filter device is installed/retrieved via a direct access opening on the cooling unit system. For example, the filter device may be bendable (or flexible), such that as the filter device is installed/retrieved from the direct access opening on the cooling unit system, the shape of the filter device conforms to the space restrictions of the cooling unit system (e.g., tight spaces within the cooling unit system, arrangement of components within the cooling unit system, size of the direct access opening, and the like). In this regard, the filter device may be installed within a space-restricted location (which was previously inaccessible) within the cooling unit system and may be easily replaced during maintenance via the direct access opening on the cooling unit system.

Additionally, the present disclosure is directed to a cooling unit system including the filter device, where the filter device is arranged within the cooling unit to be proximate to the one or more coils. For example, the filter device may be positioned adjacent (e.g., directly above or next to) the one or more coils within the cooling unit system. In this regard, the one or more coils may be better utilized within the cooling unit system to increase unit efficiency based on the filter device's close proximity to the one or more coils. Further, the filtration area of the filter device may be increased to reduce air pressure drop, thereby reducing fan power and increasing the overall Efficient Energy Ratio (EER) of the cooling unit system. As such, the cooling unit system does not need an external filter module, as previously discussed above with regard to the conventional cooling unit 100, such that the filter device may be installed on existing data centers where the overall height may be limited.

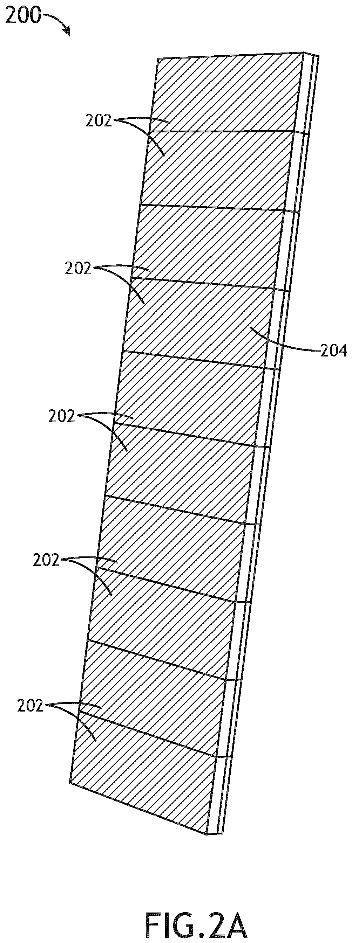

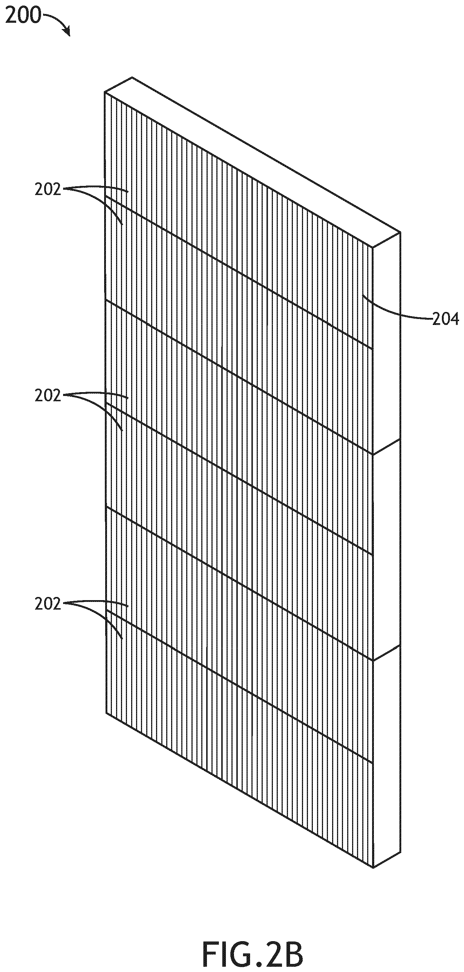

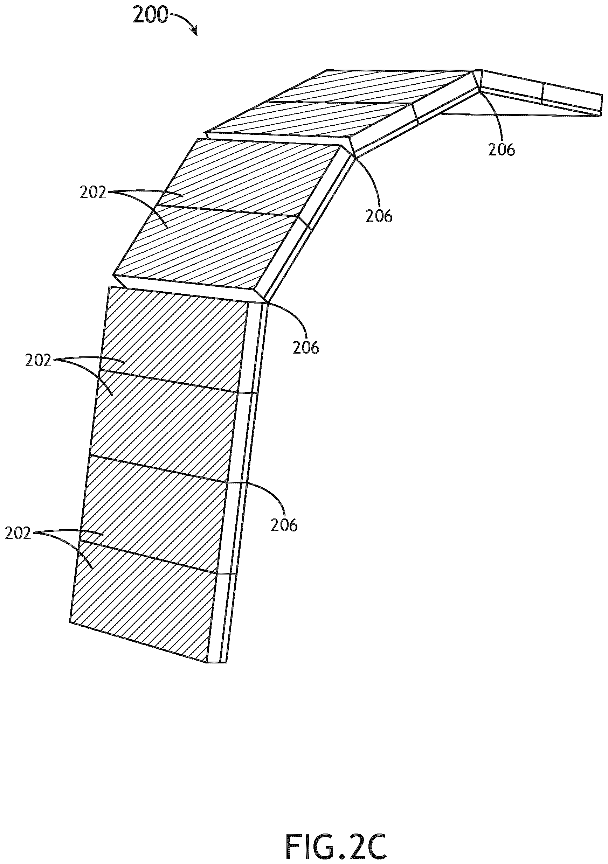

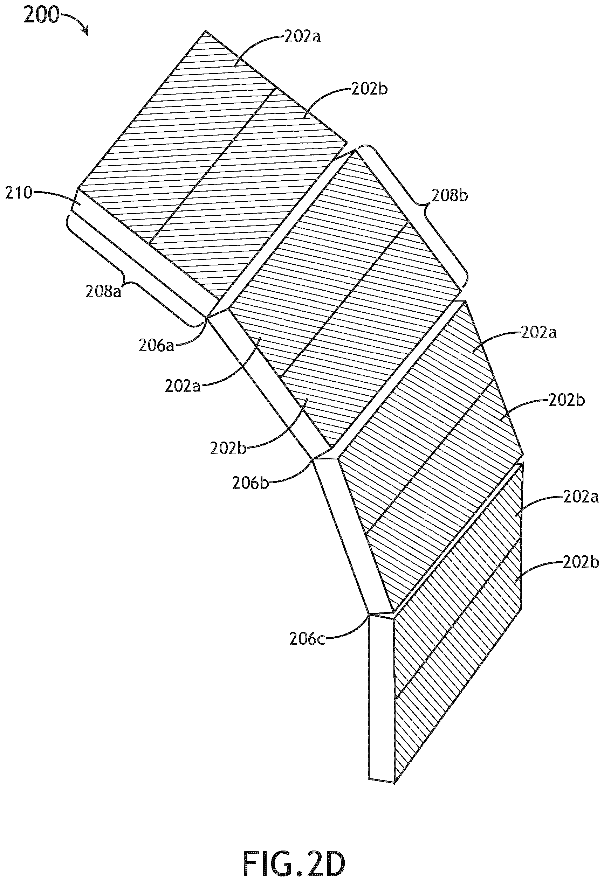

FIGS. 2A, 2B, and 2C illustrate simplified schematics of a filter device 200, in accordance with one or more embodiments of the present disclosure. FIG. 2D illustrates a simplified schematic of an array 201 of filter devices 200, in accordance with one or more embodiments of the present disclosure.

Each filter device 200 may include one or more panels 202 formed of an air filter medium 204. For example, each panel 202 may be formed of a pleated air filter medium 204. The air filter medium 204 may be any suitable air filter material such as, but not limited to, paper, foam, carbon, aluminum, steel, fiberglass, plastic, or the like.

Each filter device 200 may include any number and size of panels 202 based on the configuration of the cooling unit system, as discussed further herein. Further, it is contemplated herein that the dimensions of the filter device 200 may vary based on the dimensions/configuration of the cooling unit. In a non-limiting example, the filter device 200 may be between approximately 1-3 m in length.

Each filter device 200 may include one or more hinges 206 configured to allow the filter device 200 to bend (or fold) about an axis along the one or more hinges 206. For example, the one or more hinges 206 may include one or more living hinges configured to bend (or fold) about the axis along the one or more living hinges 206.

It is contemplated herein that for purposes of the present disclosure, a "hinge" (or variations thereof) can be any mechanical element or portion thereof facilitating bending or folding, either by construction, material type, reduced material thickness, or the like, relative to the bulk of the filter device 200. For example, the one or more living hinges may be formed of one or more bendable filter materials such as, but not limited to, paper, foam, plastic, or the like.

The one or more hinges 206 may be arranged between one or more sections of the one or more panels 202. For example, as shown in FIGS. 2C and 2D, the one or more sections may include a first section 208a including a first panel 202a and a second panel 202b and a second section 208b including a first panel 202a and a second panel 202b, where a first hinge 206a is arranged between the second panel 202b of the first section 208a and the first panel 202a of the adjacent section 208b. For instance, the first section 208a including the first panel 202a and the second panel 202b may bend about the first hinge 206a. In this regard, as the filter device 200 is installed/retrieved from the cooling unit (as discussed further herein), the sections of the filter device 200 may bend via the hinge 206, where the individual panels 202 remain substantially planar (e.g., do not bend).

Although FIGS. 2C and 2D depict each section 208a-208d including the two panels 202a, 202b, it is contemplated herein the filter device 200 may include any number of sections with any number of panels 202 (e.g., single panel, double panel, triple panel, or the like). Further, it is contemplated herein that the filter device 200 may include any number of hinges 206 suitable for bending the filter device 200 to accommodate the configuration of the respective cooling unit, as discussed further herein. As such, FIGS. 2C and 2D are provided merely for illustrative purposes and shall not be construed as limiting the scope of the present disclosure.

It is contemplated herein that the one or more sections may bend about a specific bend angle to accommodate the configuration of the respective cooling unit. For example, in a non-limiting example, the first section 208a may have a first bend angle about an axis of the first hinge 206a and the second section 208b may have a second bend angle about an axis of the second hinge 206b. In some instances, the first bend angle of the first section 208a may be similar to the second bend angle of the second section 208b. In additional instances, the first bend angle of the first section 208a may be different from the second bend angle of the second section 208b.

Each section 208a-208d of the filter device 200 may include a support frame member 210. The support frame member 210 may be formed of a rigid material (e.g., cardboard, plastic, or the like) to provide support along the perimeter of the filter device 200. For example, as shown in FIG. 2D, each section 208a-208d may include a support member 210 along an edge of the section, such that the perimeter of the section 208a-208d is formed of a plurality of support members 210. In this regard, as the section bends, the one or more panels 202 of the respective section are supported by the respective support members 210. In an embodiment, the support frame member 210 can stiffen a corresponding section. Accordingly, the hinges 206 can allow the overall filter device 200 to be maneuvered into place in spite of the stiffened sections.

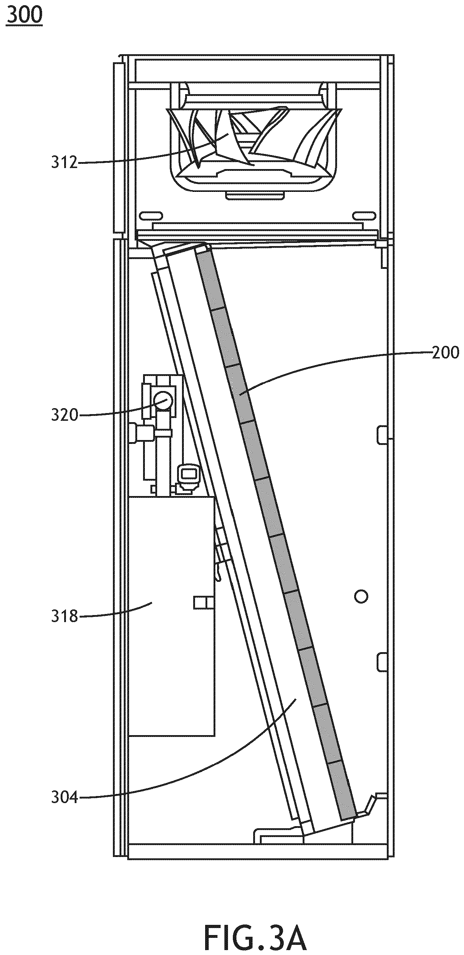

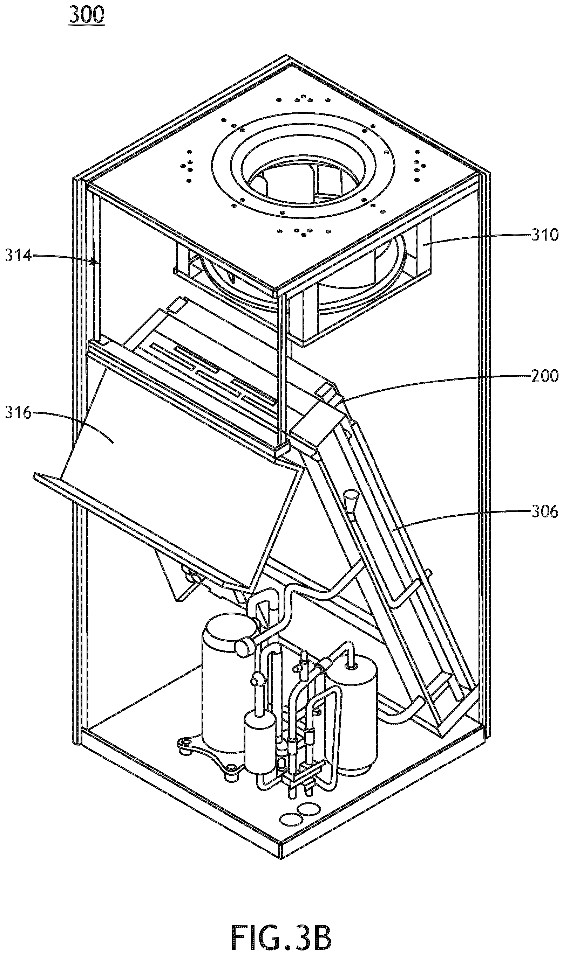

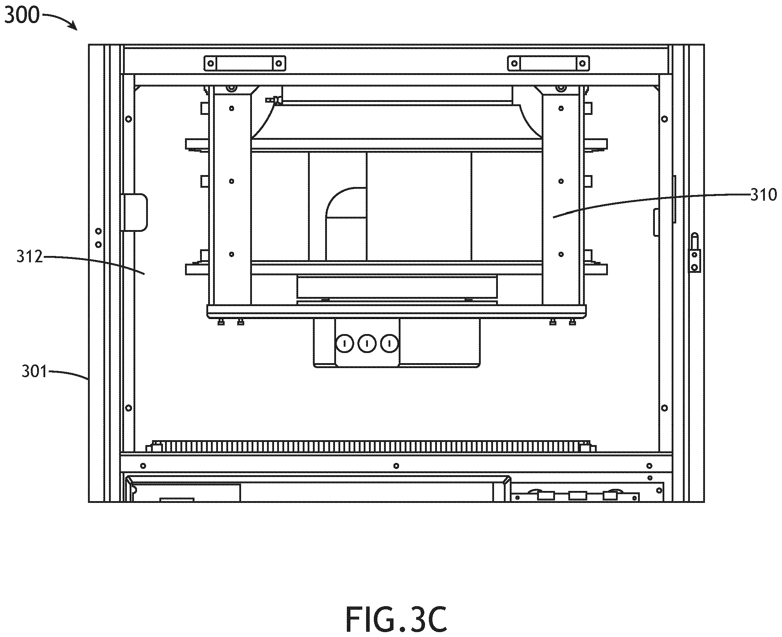

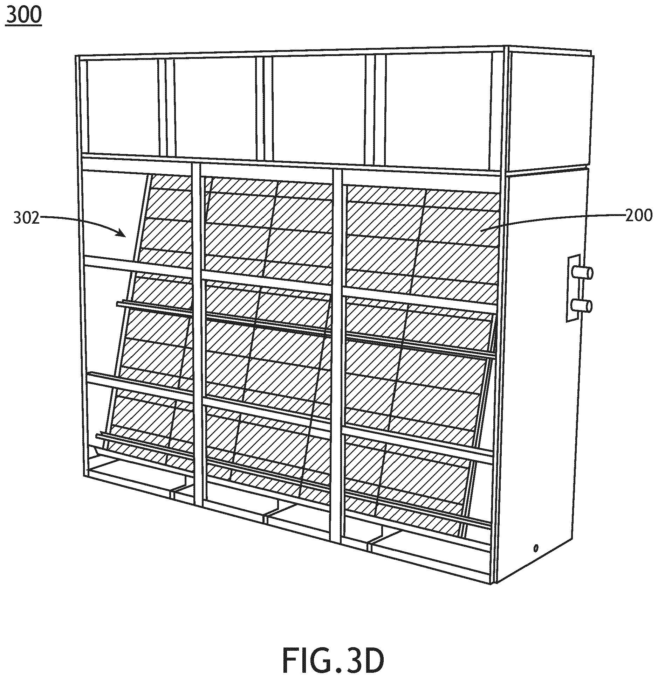

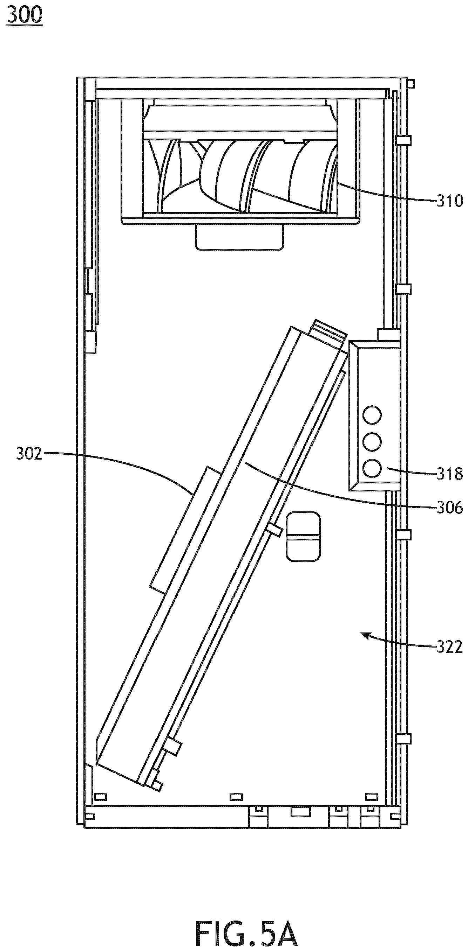

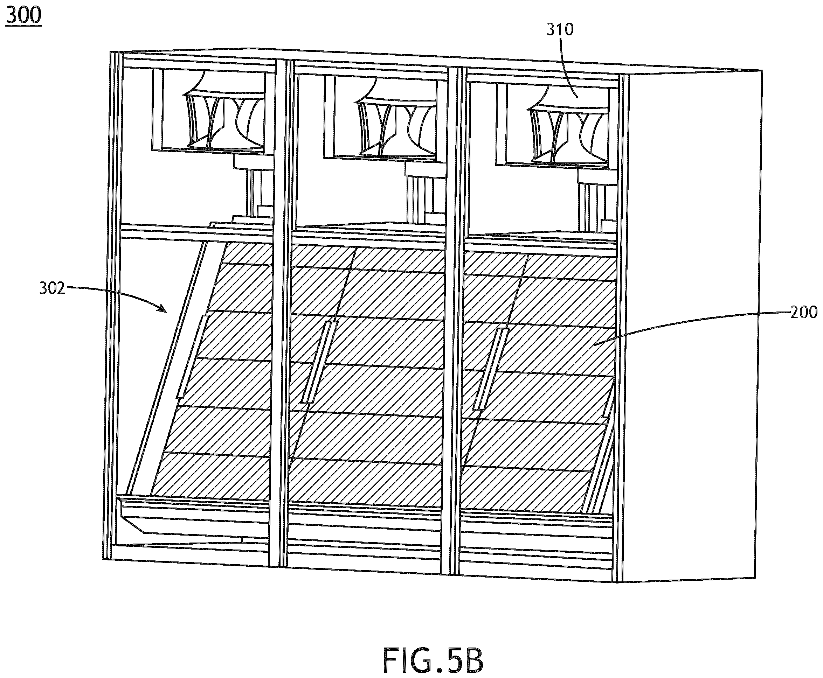

FIGS. 3A, 3B, 3C, and 3D illustrate simplified schematics of the cooling unit system 300 including the one or more filter devices 200, in accordance with one or more embodiments of the present disclosure. FIGS. 5A and 5B illustrate simplified schematics of the cooling unit system 300 including the one or more filter devices 200, in accordance with one or more embodiments of the present disclosure. For purposes of the present disclosure, the term "cooling unit system 300", "cooling unit 300", "cooling system 300", "system 300", and variations thereof may be considered equivalent, unless otherwise noted herein.

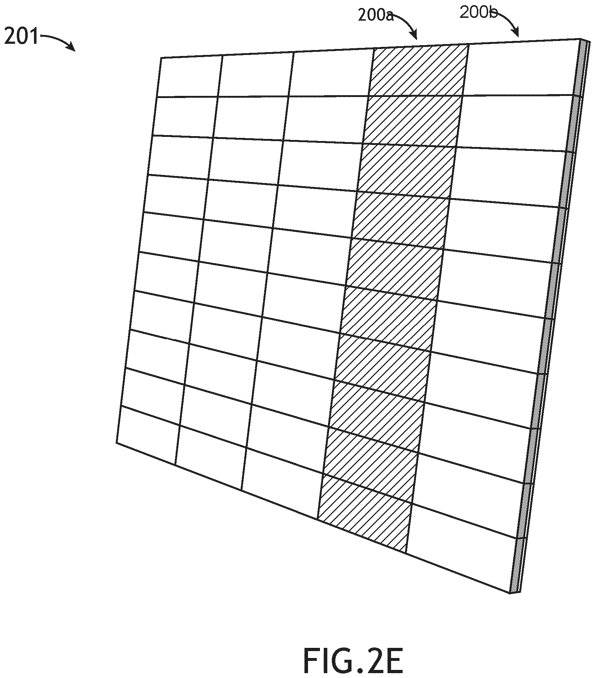

The one or more filter devices 200 may be installed within one or more cooling unit systems 300. For example, the cooling unit system 300 may include one or more individual filter devices 200, as shown in FIGS. 2A, 2B, 2C, and 2D. In one instance, the cooling unit system 300 may include a single filter device 200. In another instance, the cooling unit system 300 may include a plurality of filter devices 200. By way of another example, the cooling unit system 300 may include an array 201 of filter devices 200, as shown in FIG. 2E. In one instance, the cooling unit system 300 may include a single array 201 of filter devices 200. In another instance, the cooling unit system 300 may include a plurality of arrays 201 of filter devices 200.

The one or more filter devices 200 may be installed within one or more filter spaces 302 in the cooling unit system 300. For example, the one or more filter spaces 302 may be arranged proximate to (or adjacent to) a coil location 304 within the cooling unit system 300, where the one or more filter spaces 302 may be at least partially defined by one or more surfaces of the coil location 304, such that when the filter device 200 is installed, the filter device 200 is arranged proximate to (or adjacent to) one or more coils 306. For instance, as shown in FIGS. 3B and 5B, the one or more filter devices 200 may be arranged parallel to the coil location 304, such that the one or more filter devices 200 may be arranged proximate to a full length of the one or more coils 306. In this regard, the one or more filter devices 200 may be arranged above the one or more coils 306 for a frontal or downflow application.

The cooling unit system 300 may include the one or more coils 306 (also known as heat exchanges, condensers/evaporators, or the like). For example, the cooling unit system 300 may include a singular coil 306. By way of another example, the cooling unit system 300 may include a plurality of coils 306, as discussed further herein. It is contemplated herein that the cooling unit system 300 may include any type of coil 306, therefore the above description and associated figures shall not be construed as limiting the scope of the present disclosure. For example, the cooling unit system 300 may include a "v-coil" assembly including one or more "v-shaped" coils. By way of another example, the cooling unit system 300 may include a slab coil assembly including one or more slab coils.

As previously discussed herein, existing filter devices are often positioned greater than 1 meter away from the coils. It is contemplated herein that the one or more filter devices 200, when installed, may be in close proximity to the one or more coils 306, such that the gap between the one or more filter devices 200 and the one or more coils 306 is less than 1 meter. For example, the one or more filter devices 200 may be in direct contact with the one or more coils 306. For instance, the gap between the one or more filter devices 200 and the one or more coils 306 may be minimal (e.g., no gap or a nominal gap). In a non-limiting example, the one or more filter devices 200 may be positioned between approximately 0 cm and 25 cm away from the one or more coils 306. For example, the one or more filter devices 200 may be positioned less than 10 cm away from the one or more coils 306. In one instance, the one or more filter devices 200 may be positioned between approximately 6 cm and 10 cm away from the one or more coils 306. In another instance, the one or more filter devices 200 may be positioned approximately 1 cm away from the one or more coils 306.

It is contemplated that the location of the filter device(s) 200 with respect to the location of the coils 306 (e.g., the direct contact between the filter device(s) 200 and the coils 306) provides a number of advantages. For example, the surface area of the filter device(s) 200 is increased. By way of another example, the air pressure drop is reduced. Further, by placing the filter device(s) 200 above the coils, the unit efficiency and cooling density are increased since the coils 306 are better utilized within the cooling unit system 300 due to the filter device's close proximity to the coils.

It is contemplated that the one or more filter spaces 302 may be considered spaces within the cooling unit system 300 that were previously inaccessible and incompatible with housing conventional filter devices given the size and location of the one or more filter spaces 302.

The cooling unit system 300 may further include one or more fans 310. For example, the cooling unit system 300 may include a singular fan 310. By way of another example, the cooling unit system 300 may include a plurality of fans 310.

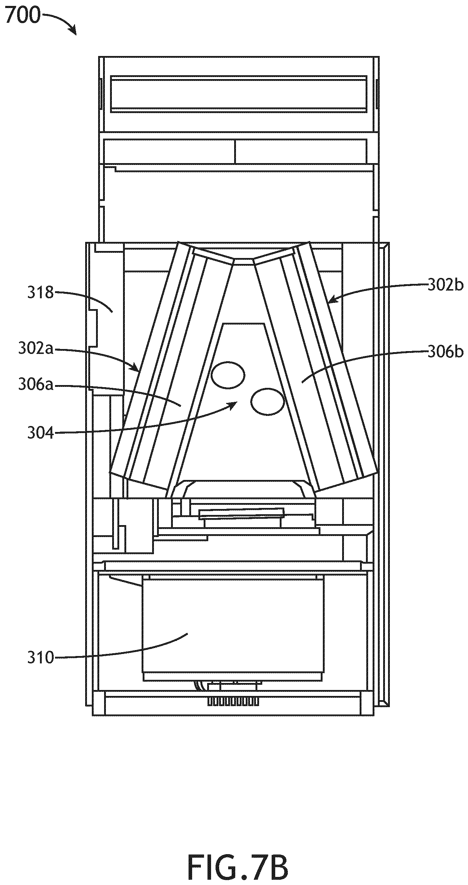

The one or more fans 310 may be located within one or more fan space 312 within the cooling unit system 300. For example, as shown in FIG. 3B, the fan space 312 may be arranged in a top portion of the cooling unit system 300. By way of another example, as shown in FIG. 7B and discussed further herein, the fan space 312 may be arranged in a bottom portion of the cooling unit system 300.

The one or more filter devices 200 may be installed or retrieved from the cooling unit system 300 via a direct access opening 314. For example, as shown in FIG. 3B, the direct access opening 314 may be arranged on a front surface (or front portion) of the cooling unit system 300. In this regard, the one or more filter devices 200 may be installed or retrieved from the cooling unit system 300 from the front surface (or front portion) of the cooling unit system 300 via the direct access opening 314.

Referring to FIGS. 2C, 2D, and 3C, each filter device 200 may be configured to bend (or fold), such that the filter device 200 may be installed or removed via a clearance space 301. The clearance space 301 may be a very limited space (e.g., approximately 200 nm), such that removing/installing the filter device 200 via the clearance space 301 is difficult. For example, as shown in FIG. 3C, the clearance space 301 may be defined between a fan space 312 and a portion of the filter space 302, where the filter device 200 may be configured to conform to the size of the clearance space 301 such that the filter device 200 may be retrieved from the filter space 302 or installed within the filter space 302.

The direct access opening 314 may be coupled to a door 316. For example, the direct accessing opening 314 may be coupled to a rotatable door. For instance, as shown in FIG. 3B, the door 316 may be opened to provide access to the filter device 200 within the cooling unit system 300, such that the filter device 200 may be installed or retrieved from the space 302 within the cooling unit system 300.

Referring again to FIG. 3A, the cooling unit system 300 may include an electrical panel located within an electrical panel location 318. Further, the cooling unit system 300 may include one or more pipes located within a piping location 320.

Referring to FIG. 5A, the cooling unit system 300 may include a refrigerant circuit location 322 configured to house one or more refrigerants within the cooling unit system 300.

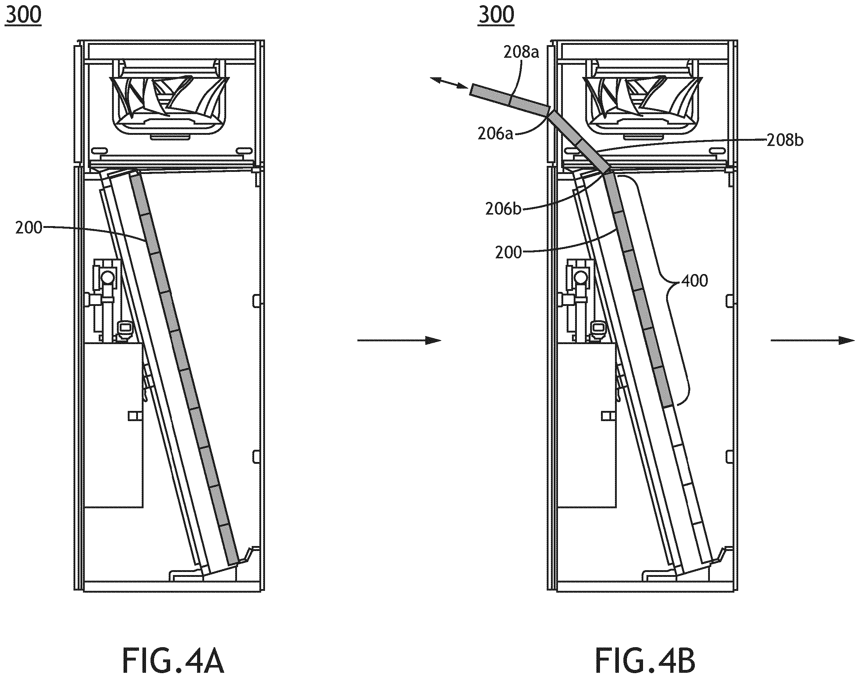

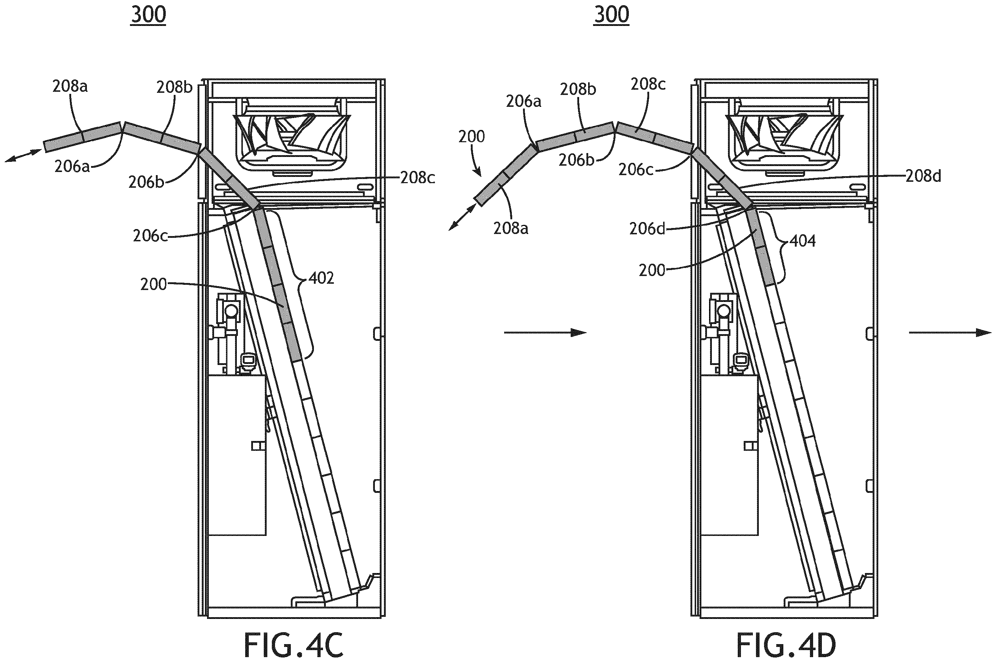

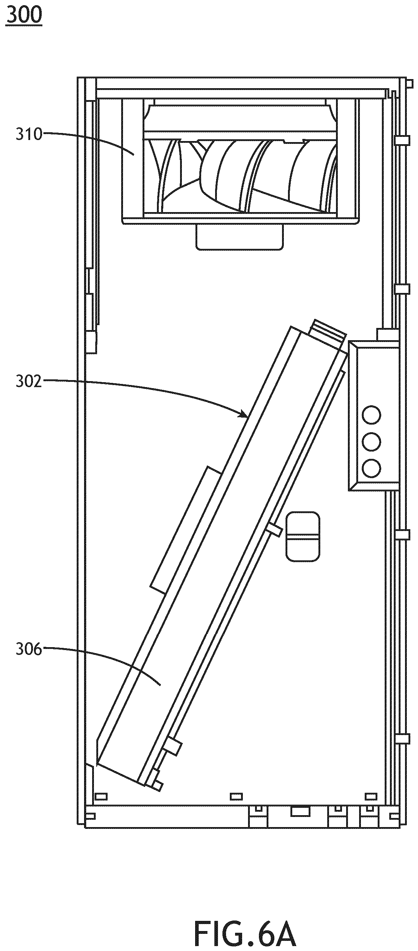

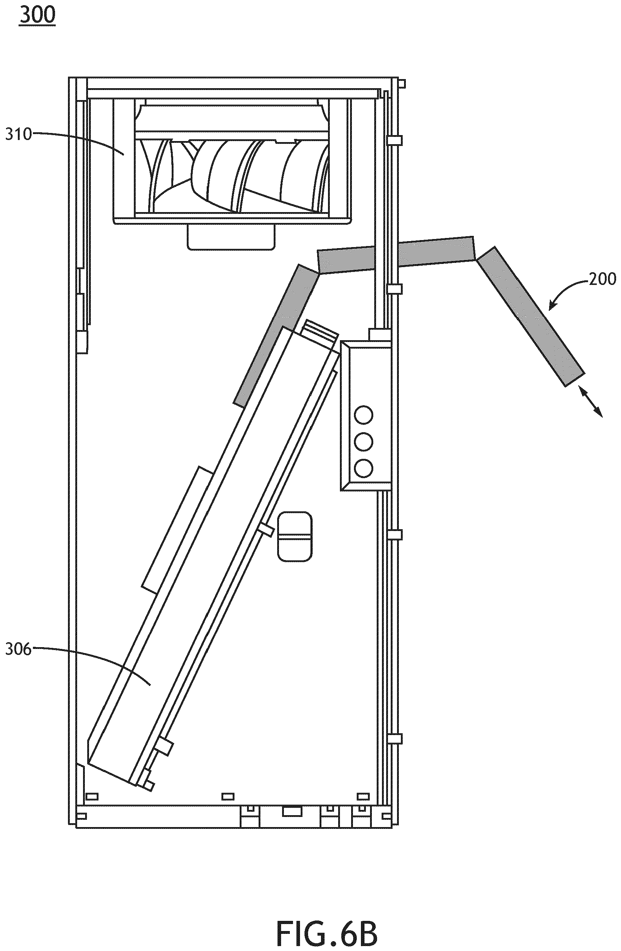

FIGS. 4A, 4B, 4C, and 4D depict schematic views of a method for retrieving (removing) the filter device 200 from the space 302 within the cooling unit system 300, in accordance with one or more embodiments of the present disclosure. FIGS. 6A and 6B depict schematic views of a method for retrieving (removing) the filter device 200 from the space 302 within the cooling unit system 300, in accordance with one or more embodiments of the present disclosure.

For example, as shown in FIGS. 4A and 6A, the filter device 200 may be installed (or disposed) within the space 302 within the cooling unit system 300. For instance, the filter device 200 may be installed directly above the coil location 304, such that the filter device 200 is arranged proximate to a full length of the one or more coils 306.

The filter device 200 may be bendable. For example, the shape of the filter device 200 may conform to the space-restrictions of the cooling unit system 300. For instance, the filter device 200 may bend (or fold) as the filter device 200 is pulled out of the direct access opening 314, such that as the filter device 200 is retrieved, the respective section(s) may bend via the respective hinge(s) 206 based on the size/configuration of the clearance space 301 of the direct access opening 314. In this regard, a planar portion of the filter device 200 may be within the space 302, where the filter device 200 is configured to bend via the hinges 206, such that the filter device 200 may be removed from the limited space between the coil edge and fan.

In a non-limiting example, as shown in FIG. 4B, a first section 208a of the filter device 200 may bend via first hinge 206a to pull out the first section 208a of the filter device 200 from the direct access opening 314. As the first section 208a is pulled out, the second section 208b of the filter device 200 may bend via a second hinge 206b, where a planar portion 400 is within the space 302 of the cooling unit system 300.

Continuing with the above non-limiting example, as shown in FIG. 4C, once the first section 208a and the second section 208b are pulled out, a third section 208c of the filter device 200 may bend via third hinge 206c to pull out the third section 208c of the filter device 200 from the direct access opening 314, where a planar portion 402 is within the space 302 of the cooling unit system 300.

Continuing with the above non-limiting example, as shown in FIG. 4D, once the first section 208a, the second section 208b, and the third section 208c are pulled out, a fourth section 208d of the filter device 200 may bend via fourth hinge 206d to pull out the fourth section 208d of the filter device 200 from the direct access opening 314, where a planar portion 404 is within the space 302 of the cooling unit system 300.

Continuing with the above non-limiting example, although not shown, once the first section 208a, the second section 208b, the third section 208c, and the fourth section 208d are pulled out, a fifth section of the filter device 200 may bend via fifth hinge to pull out the fifth section of the filter device 200 from the direct access opening 314, such that the entire filter device 200 is removed from the cooling unit system 300.

In a non-limiting example, the filter device 200 may be installed (or disposed) within the space 302 of the cooling unit system 300 by inserting the fifth section of the filter device 200 into the direct access opening 314, where the fifth section of the filter device 200 may unbend via the fifth hinge. In this regard, the fifth section may form a planar portion within the space 302 of the cooling unit.

Continuing with the above example, once the fifth section is installed, the fourth section may be inserted into the direct access opening 314, where the fourth section of the filter device 200 may unbend via the fourth hinge. In this regard, the fifth section and the fourth section may form a planar portion within the space 302 of the cooling unit.

Continuing with the above example, once the fifth section and the fourth section are installed, the third section may be inserted into the direct access opening 314, where the third section of the filter device 200 may unbend via the third hinge. In this regard, the fifth section, the fourth section, and the third section may form a planar portion within the space 302 of the cooling unit.

Continuing with the above example, once the fifth section, the fourth section, and the third section are installed, the second section may be inserted into the direct access opening 314, where the second section of the filter device 200 may unbend via the second hinge. In this regard, the fifth section, the fourth section, the third section, and the second section may form a planar portion within the space 302 of the cooling unit.

Continuing with the above example, once the fifth section, the fourth section, the third section, and the second section are installed, the first section may be inserted into the direct access opening 314, where the first section of the filter device 200 may unbend via the first hinge. In this regard, the fifth section, the fourth section, the third section, the second section, and the first section may form a planar portion within the space 302 of the cooling unit, such that the filter device 200 is fully installed (or fully disposed) within the space 302 of the cooling unit.

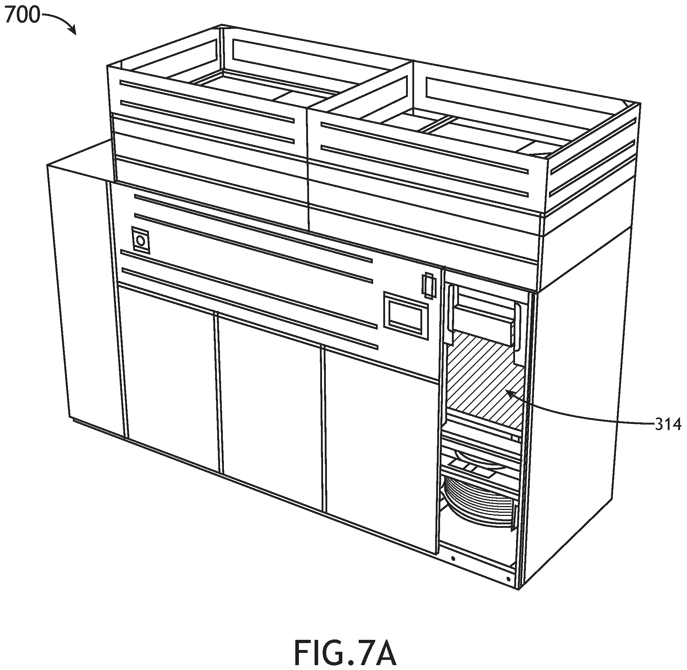

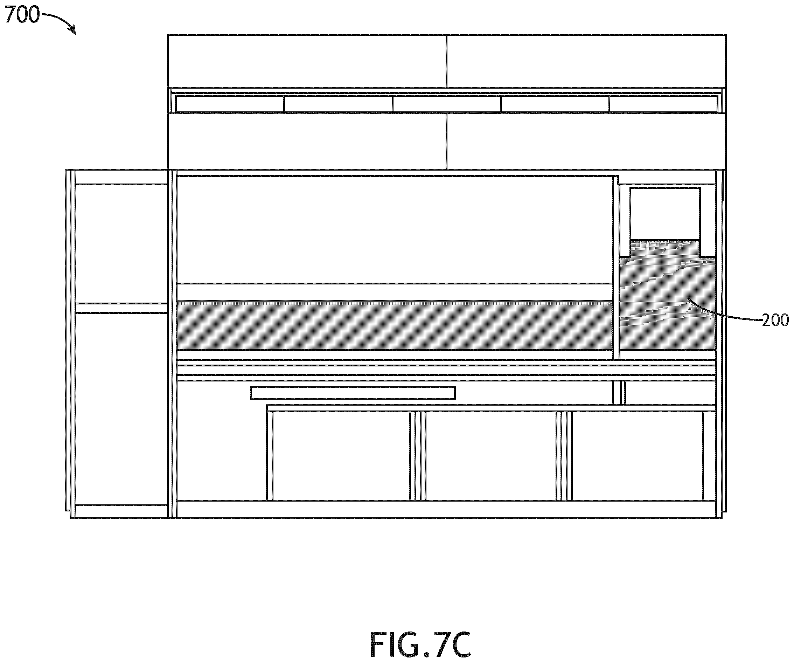

FIGS. 7A, 7B, and 7C illustrate simplified schematics of a dual-coil cooling unit system 700 including the one or more filter devices 200, in accordance with one or more embodiments of the present disclosure. It is contemplated herein that the above discussion related to the cooling unit system 300 may be applicable to the dual-coil cooling unit system 700, and vice versa, unless otherwise noted herein.

The cooling unit 700 may include a plurality of coils 306 arranged in a coil location 304 and one or more fans 310 arranged in a fan space 312. For example, the cooling unit 700 may include a dual-coil cooling unit 700 including at least two coils 306. For instance, as shown in FIG. 7B, the dual-coil cooling unit system 700 may include at least a first coil 306a and a second coil 306b. Further, the cooling unit 700 may include the one or more fans 310 arranged below the plurality of coils 306.

In this regard, the cooling unit 700 may include a plurality of spaces 302 arranged adjacent to the coils 306a, 306b. For example, as shown in FIG. 7B, the cooling unit 700 may include at least a first space 302a arranged adjacent to the first coil 306a and a second space 302b arranged adjacent to the second coil 306b. For instance, the first space 302a may be configured to receive at least a first filter device 200a and the second space 302b may receive a second filter device 200b, where the first filter device 200a is arranged adjacent to the first coil 306a and the second filter device 200b is arranged adjacent to the second coil 306b.

As previously discussed herein, it is contemplated that the bendable design of the filter device 200 allows the filter device 200 to be easily replaced and inspected.

Although embodiments of the present disclosure are directed towards a cooling unit system 300 for a data center, it is contemplated herein that the filter device 200 may be used for any critical infrastructure application (e.g., museums, hospitals, office buildings, and the like).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.

Also disclosed are the following numbered clauses:
1. A cooling system comprising:
   a filter device configured to be disposed within a space of the cooling system, the filter device comprising:
      a plurality of sections including one or more panels, the one or more panels defined by one or more air filter media; and
      one or more hinges arranged between two or more sections of the plurality of sections;
   a direct access opening, the direct access opening is configured to provide access to the space of the cooling system, the filter device configured to be disposed within the space and configured to be retrieved from the space via the direct access opening;
   a coil arranged adjacent the space of the cooling system; and
   a fan,
   wherein, when the filter device is disposed within the space, the filter device is arranged parallel to the coil, and
   wherein, when the filter device is retrieved from the space via the direct access opening, a first section is configured to bend via at least a first hinge of the one or more hinges to retrieve the first section from the space via the direct access opening.
2. The cooling system of clause 1, wherein when the first section bends via the at least the first hinge of the one or more hinges to retrieve the first section from the space, a second section adjacent to the first section is configured to bend via at least a second hinge of the one or more hinges to retrieve the second section from the space via the direct access opening.
3. The cooling system of clause 2, wherein the first section includes a first panel and a second panel, and the second section includes a first panel and a second panel.
4. The cooling system of clause 3, wherein the first panel and the second panel of the first section and the first panel and the second panel of the second section remain substantially planar when the first section bends via the first hinge and the second section bends via the second hinge.
5. The cooling system of clause 2, wherein the first section has a first bend angle about an axis of the first hinge and the second section has a second bend angle about an axis of the second hinge.
6. The cooling system of clause 5, wherein the first bend angle of the first section is equal to the second bend angle of the second section.
7. The cooling system of clause 5, wherein the first bend angle of the first section is different from the second bend angle of the second section.
8. The cooling system of clause 1, wherein the filter device is arranged proximate to a full length of the coil when disposed within the space.
9. The cooling system of clause 1, wherein the filter device is configured to be disposed on a top surface of the coil.
10. The cooling system of clause 1, wherein the one or more hinges comprise:
   one or more living hinges.
11. The cooling system of clause 1, wherein the direct access opening is arranged on a front surface of the cooling system.
12. The cooling system of clause 1, wherein the direct access opening includes a door.
13. The cooling system of clause 1, wherein a distance between the filter device and the coil is between 0 cm and 25 cm.
14. The cooling system of clause 13, wherein the distance between the filter device and the coil is less than 10 cm.
15. A filter device comprising:
   a plurality of sections including one or more panels, the one or more panels defined by one or more air filter media; and
   one or more hinges arranged between two or more sections of the plurality of sections,
   wherein the filter device is configured to be disposed within a space,
   wherein the filter device is configured to be retrieved from the space,
   wherein, when the filter device is disposed within the space, the filter device is configured to be arranged parallel to a coil, and
   wherein when the filter device is retrieved from the space, a first section is configured to bend via a first hinge of the one or more hinges to retrieve the first section from the space.
16. The filter device of clause 15, wherein the filter device is arranged proximate to a full length of the coil when disposed within the space.
17. The filter device of clause 15, wherein the filter device is configured to be disposed on a top surface of the coil.
18. The filter device of clause 15, wherein the one or more hinges comprise:
   one or more living hinges.
19. The filter device of clause 15, wherein a distance between the filter device and the coil is between 0 cm and 25 cm.
20. The filter device of clause 19, wherein the distance between the filter device and the coil is less than 10 cm.

## Claims

1. A filter device (200) comprising:
a plurality of sections including one or more panels (202), the one or more panels defined by one or more air filter media (204); and
one or more hinges (206) arranged between two or more sections of the plurality of sections,
wherein the filter device is configured to be disposed within a space,
wherein the filter device is configured to be retrieved from the space, wherein, when the filter device is disposed within the space, the filter device is configured to be arranged parallel to a coil (306), and
wherein when the filter device is retrieved from the space, a first section is configured to bend via a first hinge (206a) of the one or more hinges to retrieve the first section from the space.

2. The filter device of claim 1, wherein the filter device is arranged proximate to a full length of the coil when disposed within the space.

3. The filter device of claim 1 or 2, wherein the filter device is configured to be disposed on a top surface of the coil.

4. The filter device of any preceding claim, wherein the one or more hinges comprise:
one or more living hinges.

5. The filter device of any preceding claim, wherein a distance between the filter device and the coil is between 0 cm and 25 cm.

6. The filter device of any preceding claim, wherein the distance between the filter device and the coil is less than 10 cm.

7. A cooling system (300) comprising:
a filter device (200) according to any preceding claim configured to be disposed within a space (302) of the cooling system;
a direct access opening (314), wherein the direct access opening is configured to provide access to the space of the cooling system, the filter device configured to be disposed within the space and configured to be retrieved from the space via the direct access opening;
a coil (306) arranged adjacent the space of the cooling system; and
a fan (310),
wherein, when the filter device is disposed within the space, the filter device is arranged parallel to the coil, and
wherein, when the filter device is retrieved from the space via the direct access opening, a first section is configured to bend via at least a first hinge (206a) of the one or more hinges to retrieve the first section from the space via the direct access opening.

8. The cooling system of claim 7, wherein when the first section bends via the at least the first hinge of the one or more hinges to retrieve the first section from the space, a second section adjacent to the first section is configured to bend via at least a second hinge (206b) of the one or more hinges to retrieve the second section from the space via the direct access opening.

9. The cooling system of claim 8, wherein the first section includes a first panel (202a) and a second panel (202b), and the second section includes a first panel and a second panel.

10. The cooling system of claim 9, wherein the first panel and the second panel of the first section and the first panel and the second panel of the second section remain substantially planar when the first section bends via the first hinge and the second section bends via the second hinge.

11. The cooling system of any of claims 8 to 10, wherein the first section has a first bend angle about an axis of the first hinge and the second section has a second bend angle about an axis of the second hinge.

12. The cooling system of claim 11, wherein the first bend angle of the first section is equal to the second bend angle of the second section.

13. The cooling system of claim 11 or 12, wherein the first bend angle of the first section is different from the second bend angle of the second section.

14. The cooling system of any of claims 7 to 13, wherein the direct access opening is arranged on a front surface of the cooling system.

15. The cooling system of any of claims 7 to 14, wherein the direct access opening includes a door (316).
